(19) **Europäisches Patentamt**
**European Patent Office**
**Office européen des brevets**

(11) **EP 1 922 773 B1**

(12) **EUROPEAN PATENT SPECIFICATION**

(45) Date of publication and mention
of the grant of the patent:
**25.12.2013 Bulletin 2013/52**

(51) Int Cl.:
***H01L 51/05*** ***(2006.01)***

(21) Application number: **05709076.3**

(22) Date of filing: **23.03.2005**

(86) International application number:
**PCT/IB2005/050997**

(87) International publication number:
**WO 2006/100545 (28.09.2006 Gazette 2006/39)**

(54) **PERYLENE IMIDE/DIIMIDE BASED ORGANIC FIELD EFFECT TRANSISTORS-OFETS AND A METHOD OF PRODUCING THE SAME**

AUF PERYLENIMID/-DIIMID BASIERENDE ORGANISCHE FELDEFFEKTTRANSISTOREN - OFETS UND VERFAHREN ZU IHRER HERSTELLUNG

TRANSISTORS A EFFET DE CHAMP ORGANIQUES (OFET) A BASE DE PERYLENE IMIDE/DIIMIDE ET LEUR PROCEDE DE PRODUCTION

(84) Designated Contracting States:
**AT BE BG CH CY CZ DE DK EE ES FI FR GB GR HU IE IS IT LI LT LU MC NL PL PT RO SE SI SK TR**

(43) Date of publication of application:
**21.05.2008 Bulletin 2008/21**

(60) Divisional application:
**10178379.3 / 2 259 354**

(73) Proprietor: **Türkiye Sise Ve Cam Fabrikalari A.S.**
**34130 Istanbul (TR)**

(72) Inventors:
• **ICLI, Siddik**
**35100 Izmir (TR)**
• **SARICIFTCI, Serdar,**
**Linz Inst. for Organic Solar**
**Johannes Kepler Universitat, A-4040 Linz (AT)**
• **ERTEN, Sule**
**35100 Izmir (TR)**
• **BIRENDRA, Singh,**
**Linz Institute for Organic Solar**
**Johannes Kepler Universitat, A-4040 Linz (AT)**
• **YILDIRIM, Teoman,**
**Türkiye Sise ve Cam Fabrik. A.S.**
**341330 Istanbul (TR)**
• **KUBAN, Baha,**
**Türkiye Sise ve Cam Fabrik. A.S.**
**341330 Istanbul (TR)**

(74) Representative: **Hofstetter, Schurack & Partner**
**Patent- und Rechtsanwaltskanzlei**
**Partnerschaft**
**Balanstrasse 57**
**81541 München (DE)**

(56) References cited:
**EP-A- 1 041 653         WO-A-03/052841**
**WO-A-2004/100281**

• SCHROEDER R ET AL: "IMPROVING ORGANIC TRANSISTOR PERFORMANCE WITH SCHOTTKY CONTACTS" APPLIED PHYSICS LETTERS, AIP, AMERICAN INSTITUTE OF PHYSICS, MELVILLE, NY, US, vol. 84, no. 6, 9 February 2004 (2004-02-09), pages 1004-1006, XP001197588 ISSN: 0003-6951
• CHUA L-L ET AL: "General observation of n-type field-effect behavior in organic semiconductors" NATURE, NATURE PUBLISHING GROUP, LONDON, GB, vol. 434, no. 7030, 10 March 2005 (2005-03-10), pages 194-199, XP002327479 ISSN: 0028-0836
• MIHAILETCHI V D ET AL: "ELECTRON TRANSPORT IN A METHANOFULLERENE" ADVANCED FUNCTIONAL MATERIALS, WILEY VCH, WIENHEIM, DE, vol. 13, no. 1, January 2003 (2003-01), pages 43-46, XP001142615 ISSN: 1616-301X
• PARASHKOV R ET AL: "All-organic field effect transistors" MATERIALS RESEARCH SOCIETY SYMPOSIUM - PROCEEDINGS 2003, vol. 769, 2003, pages 81-84, XP002354187

EP 1 922 773 B1

**Description**

In organic electronics, much progress has been made in recent years in the development of FET based on organic semi conductors, OFETs. Related information can be found in Applied Physics Letters by Th. B. Singh et al. Appl. Phys. Lett. 85, 5409 (2004); Nanoelectronics and Information Technology: Advanced Elecronics Materials and Novel Devices, edited by R.Waser (2003) and C. D. Dimitrakopoulos and D. J. Mascaro, IBM J. Res. Dev., 45, 11 (2001); G. Horowitz, Adv. Funct. Mater., 13, 53 (2003).

There has been a growing interest in researches on OFETs with high mobility ($\mu$) utilizing the large field of material chemistry. (See. V. Podzorov, S. E. Sysoev, E. Loginova, V. M. Pu-dalov and M. E. Gershenson, Appl. Phys. Lett., 83, 3504 (2003)).

OFET-Organic field-effect transistors among the general organic electronic devices are of great interest for switching devices, flexible displays, smart cards and in large area sensors. The advantage of these devices are the combination of solution processable and potentially lower cost fabrications such as printing over the existing device technology.

OFET applications using low-cost production and large area coverage such as radio frequency IDs, smart tags, textile integrated electronics, etc.. are known. For reference, see J. A. Rogers, Z. bao, K. Baldwin, A. Dodabalapur, B. Crone, V. R. Raju, V. Kuck, H. Katz, K. Amundson, J. Ewing and P. Drzaic, Proc. Natl. Acad. Sci. USA, 98, 4835 (2001).

Schroeder et al. (Schroeder, R., Majewski, L. A., Grell, M.: "Improving organic transistor performance with Schottky contact", Applied Physics Letters, AIP, American Institute of Physics, Melville, NY, US, vol. 84, no. 6, February 9, 2004, p. 1004-1006) disclose gold/ pentacene OFETs with non-Ohmic contacts.

Chua et. al. (Chua, L., Zaumsell, J., Chang, J., Ou, E., Ho, P., Sirringhaus, H., Friend, R.: "General observation of n-type field-effect behaviour in organic semiconductors", Nature, Nature Publishing Group, London, GB, vol. 434, no. 7030, March 10, 2005, p. 194-199) describe the use of hydroxyl-free gate dielectric such as divinyltetramethylsiloxane-bis(benzocyclobutene) to yield n-channel field-effect transistor conduction in conjugated polymers.

WO 03/052841 A1 describes an organic field effect device as well as a process of manufacturing an organic field effect device comprising the steps of depositing from a solution an organic semiconductor layer and depositing from a solution a layer of low permittivity insulating material forming at least a part of a gate insulator, such that the low permittivity insulating material is in contact with the organic semiconductor layer. The low permittivity insulating material is of relative permittivity from 1.1 to below 3.0.

Solution-processed large area printable OFETs have a great potential in future applications.

In the present invention, ambipolar, solution processed n-channel organic field effect transistors (OFETs) having high mobilities based on N,N'-bis-(dehydroabietyl)-3,4,9,10-perylenebis(dicarboximide), N-(cyclohexyl)perylene-3,4,9,10-tetracarboxylic-3,4-anhydride-9,10-imide or N,N'-bis-(butyl)-1,4,5,8-naphthalenebis(dicarboximide), absorbing in visible region (< 530 nm), are disclosed.

The synthesis, design and application of n-channel organic field effect transistors (OFETs) based on N,N'-bis(dehydroabietyl)-3,4,9,10-perylene diimide (PDI) derivative has shown electron mobility, $\mu_- \approx 7 \times 10^{-5}$ $cm^2.V^{-1}.s^{-1}$ and hole $\mu_- \approx 8 \times 10^{-5}$ $cm^2.V^{-1}.s^{-1}$. Less soluble, air stable, n-channel based N-(cyclohexyl)perylene-3,4,9,10-tetracarboxylic-3,4-anhydride-9,10-imide showed a mobility of $\mu_- \approx 10^{-5}$ $cm^2.V^{-1}.s^{-1}$.

PhotOFETs, functioning under solar irradiations, can also be constructed with perylene imides/diimides.

H. E. Katz reports the NDI based OFETs, constructed by vapor phase deposition. For reference see a) H. E. Katz, J. Johnson, A. J. Lovinger and W. Li, J. Am. Chem. Soc, 122, 7787 (2000) b) H. E. Katz, W. Li, A. J. Lovinger, US Patent (2002), (Agere Systems Guardian Corp., USA), USXXAM US 6387727 B1 20020514.

The invention is described herebelow and in drawings attached hereto wherein:

Figure 1 is a scheme of the staggered mode n-channel OFET device structure.

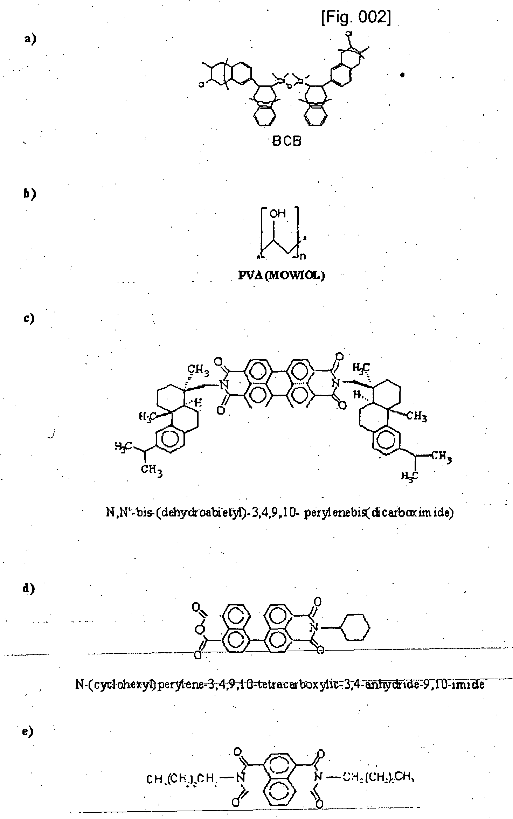

Figure 2 shows the molecular structures employed in OFETs; a) BCB dielectric polymer, b) PVA (MOWIOL) dielectric polymer, c) N,N'-bis-(dehydroabietyl)-3,4,9,10-perylenebis(dicarboximide) semiconductor, d) N-(cyclohexyl)perylene-3,4,9,10-tetracarboxylic-3,4-anhydride-9,10-imide semiconductor, and e) N,N'-bis-(butyl)-1,4,5,8-naphthalenebis(dicarboximide) semiconductor.

Figure 3 is the transistor, output $I_{ds}$ vs. $V_{ds}$, and transfer, $I_{ds}$ vs. $V_{gs}$, characteristics of OFET with N,N'-bis-(butyl)-1,4,5,8-naphthalenebis(dicarboximide) as an active semiconducting layer.

Figure 4 shows the AFM images of N,N'-bis-(butyl)-1,4,5,8-naphthalenebis(dicarboximide) thin film spin coated on top of PVA film.

Figure 5 shows output $I_{ds}$ vs. $V_{ds}$, characteristics OFET curves of ambipolar OFET with N,N'-bis-(dehydroabietyl)-3,4,9,10-perylenebis(dicarboximide) as an active semiconducting layer.

Figure 6 shows transfer $I_{ds}$ vs. $V_{gs}$ characteristics of N,N'-bis-(dehydroabietyl)-3,4,9,10-perylene-bis(dicarboximide) FET showing electron enhancement current at positive gate voltage and hole enhancement current at negative gate voltage.

Figure 7 shows AFM image of ambipolar N,N'-bis-(dehydroabietyl)-3,4,9,10-perylenebis(dicarboximide) on PVA coated film.

Solution processed n-channel organic field effect transistors (OFETs) based on N,N'-bis(butyl)-1,4,5,8-naphthalene diimide, NDI, derivative, constructed as a reference to PDI-OFET; strong electron accepting ability and good solubility have been disclosed. NDI based OFETs showed mobilities up to 0.05 $cm^2$ $V^{-1}$ $s^{-1}$ and operated both in inert conditions and air. Mobility of n-butyl NDI is higher than the reported thin film alkyl derivative of NDI OFET 0.03 $cm^2$ $V^{-1}$ $s^{-1}$[6]. Naphthalene diimides absorb in UV range, < 380 nm. The crystalline structure of NDI in OFET device is proven by atomic force microscopy (AFM) pictures.

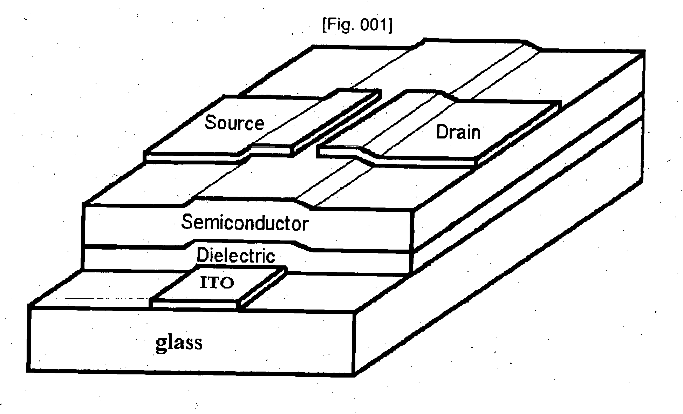

A schematic view of the device is shown in Figure 1. The manufacturing process of the device starts with etching the electrically conductive indium tin oxide (ITO) on the glass substrate. After patterning the ITO and cleaning in the ultrasonic bath, PVA (poly-vinyl alcohol) dielectric layer with average molecular weight of 127.000 (Mowiol® 40-88) from Sigma-Aldrich® is spin-coated from water solution with a 10 % wt. ratio. A highly viscous PVA solution gives a transparent film by spin coating at 1500 rpm which results in 2 $\mu$m thick film forming the dielectric layer. Same experiment was conducted with divinyltetramethyldisiloxane-bis(benzocyclobutene) BCB as dielectric layer. BCB was used as received from Dow Chemicals and curing was done according to the standard procedure which is described in Lay-Lay Chua, Peter K. H. Ho, Henning Sirringhaus and R.H. Friend, Appl. Phys. Lett., 84, 3400 (2004).

The top source and drain electrode, LiF/Al (0.6/60 nm) was evaporated under vacuum (2 x $10^{-6}$ mbar) through a shadow mask. The channel length, L of the device is 35 $\mu$m with channel width, W = 1.4 mm which resulted in W/L ratio of $\approx$ 40. From the measurement of dielectric thickness, d = 2 $\mu$m; $\varepsilon_{BCB}$ = 2.6, dielectric capacitance $C_{BCB}$ =1.2 $nF/cm^2$ was estimated. All device transport and electrical characterisation was carried out both in air and under argon environment. Keithley® 236 and Keithley® 2400 Source-Measurements Units instruments were used for the steady state current-voltage measurements. Surface morphology and thickness of the dielectric was determined with a Digital Instrument® 3100 atomic force microscope (AFM) and a Dektak® surface profilometer.

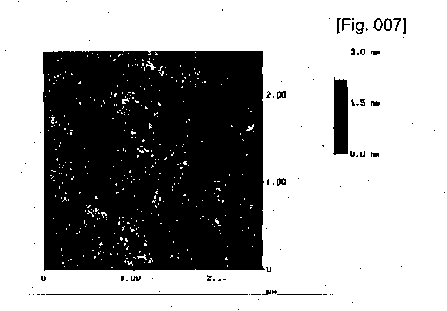

As shown in Figure 7, the semiconductor layer of dehydroabietyl perylene diimide has a very smooth surface with roughness of <5 nm, a spin coated layer at thickness of 150 nm. Perylene diimides and monoimides absorb in visible region <530 nm. In a recent study, it was proved that the first few monolayers next to the dielectric layer dominate the charge transport. See. F. Dinelli, M. Murgia, P. Levy , M. Cavallini, F. Biscarini, D. M. de Leeuw, Phys. Rev. Lett., 92, 116802 (2004).

LiF/Al has been selected as drain and source electrode as it is expected to form ohmic contact on aromatic imides. See a) V. D. Mihailetchi, J. K. J. van Duren, P. W. M. Blom, J. C. Hummelen, R. A. J. Janssen, J. M. Kroon, M. T. Rispens, W. J. H. Verhees and M. M. Wienk, Adv. Func. Mater. 13, 43 (2003). b) G. J. Matt, N. S. Sariciftci and T. Fromherz, Appl. Phys. Lett. 84, 1570 (2004).

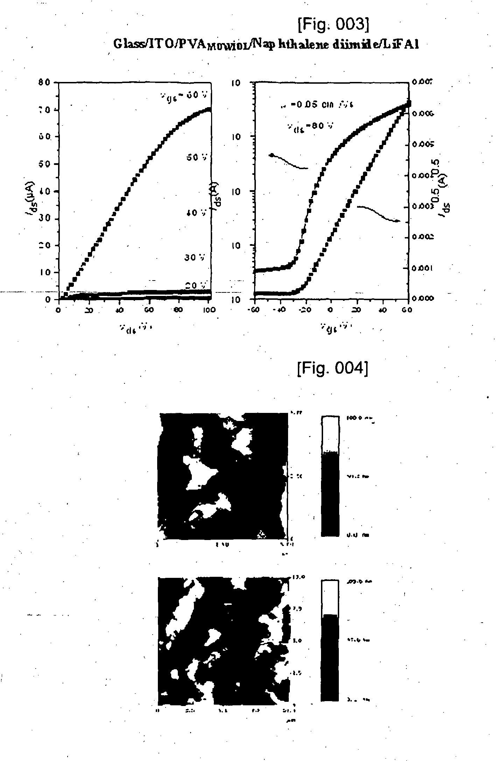

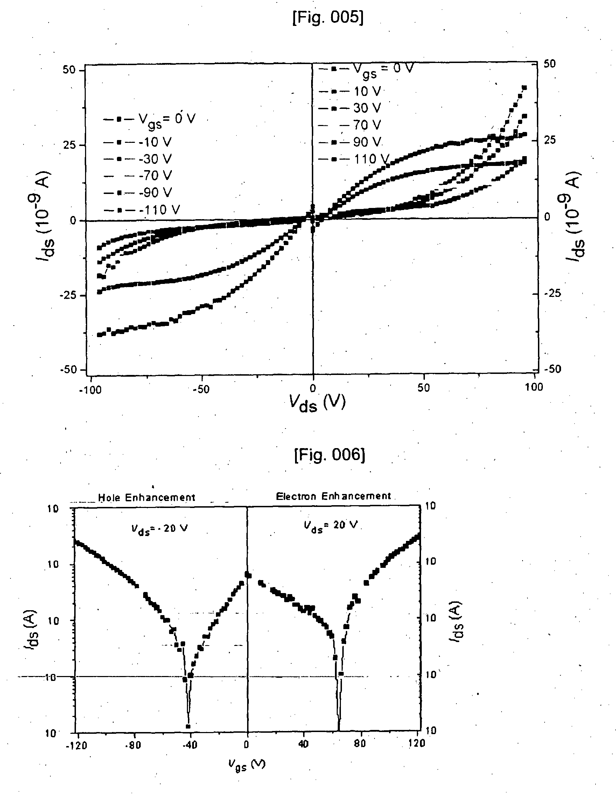

Figures 3 and 5 show the typical transistor and transfer characteristics of a device with a well saturated curve occurring pinch off at drain source voltage $V_{ds(sat)}$[3] $V_{gs}$ (gate Voltage). For the same device (Figures 3 and 5) the transfer characteristics at different $V_{ds}$ have been measured.

As seen in figures 3 and 5, according to the equation (1): (S. M. Sze, Physics of Semiconductor Devices, Wiley, New York, 1981)

$$I_{ds} = \frac{\mu W C_{BCB}}{2L} (V_g - V_t)^2$$

N,N'-bis(dehydroabietyl)-3,4,9,10-perylene diimide (PDI) derivative has shown electron mobility of $\mu$ = 7 x $10^{-5}$ $cm^2.V^{-1}.s^{-1}$ and hole mobility 8 x $10^{-5}$ $cm^2.V^{-1}.s^{-1}$. Low solubility, air stable, n-channel based N-(cyclohexyl)perylene-3,4,9,10-tetracarboxylic-3,4-anhydride-9,10-imide showed electron mobility $\mu_\varepsilon$ = $10^{-5}$ $cm^2.V^{-1}.s^{-1}$. N,N'-bis(butyl)-1,4,5,8-naphthalene diimide, NDI, derivative, constructed as a reference to PDI-OFET; strong electron accepting ability and good solubility have been featured. NDI based OFETs showed electron mobilities $\mu$ up to 0.05 $cm^2.V^{-1}.s^{-1}$ and operated in both inert conditions and air. Mobility of n-butyl NDI is higher than the reported thin film NDI OFET 0.03 $cm^2.V^{-1}.s^{-1}$. (For reference see H. E. Katz, J. Johnson, A. J. Lovinger and W. Li, J. Am. Chem. Soc, 122, 7787 (2000)).

**Claims**

1. A method of constructing a solution processed, ambipolar, air stable organic field effect transistor (OFET) comprising the steps of:

   a) patterning of electrically conductive indium tin oxide (ITO) on a glass substrate and cleaning of the patterned ITO;
   b) spin coating a transparent film of PVA (poly-vinyl alcohol) as a dielectric layer on top of the ITO;
   c) spin coating the PVA covered ITO/glass substrate with a semiconductor layer of N,N'-bis-(dehydroabietyl)-3,4,9,10-perylenebis(dicarboximide); or spin coating the PVA covered ITO/glass substrate with a semiconductor layer of N-(cyclohexyl)perylene-3,4,9,10-tetracarboxylic-3,4-anhydride-9,10-imide; or spin coating the glass substrate with a semiconductor layer of N,N'-bis-(butyl)-1,4,5,8-naphthalenebis (dicarboximide);

d) evaporating LiF/Al source and drain electrodes on top of the semiconductor layer under vacuum through a shadow mask, wherein the LiF/Al source and drain electrodes have a thickness of 0.6 nm/60 nm, respectively, a channel length of 35 $\mu$m, and a channel width of 1.4 mm.

2. An n-channel organic field effect transistor (OFET) with a solution spin coated aromatic imide/diimide semiconductor layer that absorbs in the visible region produced by the method as claimed in claim 1.

**Patentansprüche**

1. Verfahren zum Konstruieren eines lösungsbearbeiteten, ambipolaren, in Luft stabilen organischen Feldeffekttransistors (OFET) mit den Schritten:

a) Strukturieren eines elektrisch leitfähigen Indiumzinnoxids (ITO) auf einem Glassubstrat und Reinigen des strukturierten ITO;

b) Aufschleudern eines transparenten Films aus PVA (Polyvinylalkohol) als dielektrische Schicht auf das ITO;

c) Aufschleudern einer Halbleiterschicht aus N,N'-Bis-(dehydroabietyl)-3,4,9,10-perylenbis(dicarboximid) auf das mit PVA bedeckte ITO/Glassubstrat; oder Aufschleudern einer Halbleiterschicht aus N-(Cyclohexyl)perylen-3,4,9,10-tetracarbonsäure-3,4-aqnhydrid-9,10-imid auf das mit PVA bedeckte ITO/Glassubstrat; oder Aufschleudern einer Halbleiterschicht aus N,N'-Bis-(butyl)-1,4,5,8-naphthalinbis(dicarboximid) auf das Glassubstrat;

d) Aufdampfen einer LiF/Al-Quelle und von Drainelektroden auf die Halbleiterschicht unter Vakuum durch eine Schattenmaske, wobei die LiF/Al-Quelle und die Drainelektroden jeweils eine Dikke von 0,6 nm/60 nm, eine Kanallänge von 35 $\mu$m und eine Kanalbreite von 1,4 mm aufweisen.

2. Organischer n-Kanal-Feldeffekttransistor (OFET) mit einer aus Lösung aufgeschleuderten aromatischen Imid/Diimid-Halbleiterschicht, die im sichtbaren Bereich absorbiert, der durch das Verfahren nach Anspruch 1 hergestellt wird.

**Revendications**

1. Procédé de fabrication d'un transistor organique à effet de champ (TOEC), stable à l'air, ambipolaire, traité en solution, comprenant les étapes, consistant à :

a) structurer de l'oxyde d'étain et d'indium (OEI), électriquement conducteur, sur un substrat de verre et nettoyer l'OEI structuré ;

b) déposer à la tournette un film transparent d'APV (alcool de polyvinyle), en tant que couche diélectrique sur l'OEI ;

c) déposer à la tournette l'OEI / le substrat de verre, couvert d'APV, avec une couche de semiconducteurs de N,N'-bis-(déhydroabiétyle)-3,4,9,10-pérylène-bis(dicarboximide) ou déposer à tournette l'OEI / le substrat de verre, couvert d'APV, avec une couche de semi-conducteurs de N-(cyclohexyle)pérylène-3,4,9,10-tétracarboxylique-3,4-anhydride-9,10-imide ou déposer à la tournette le substrat de verre avec une couche de semi-conducteurs de N,N'-bis-(butyle)-1,4,5,8-naphthalène-bis (dicarboximide) ;

d) faire évaporer la source LiF/Al et les électrodes de drain sur la couche de semi-conducteurs, sous vide, par le biais d'un masque perforé, dans lequel la source LiF/Al et les électrodes de drain ont une épaisseur de 0,6 nm/60 nm, respectivement, une longueur de canal de 35 $\mu$m et une largeur de canal de 1,4 mm.

2. Transistor organique à effet de champ (TOEC) à n canaux, avec une couche de semi-conducteurs imide / diimide aromatique, déposée à la tournette en solution, qui absorbe dans la région visible, produit par le procédé selon la revendication 1.

[Fig. 001]

[Fig. 002]

a)

BCB

b)

$$\left[ \begin{array}{c} OH \\ \end{array} \right]_n$$

PVA (MOWIOL)

c)

N,N'-bis-(dehydroabietyl)-3,4,9,10- perylenebis(dicarboximide)

d)

N-(cyclohexyl)perylene-3,4,9,10-tetracarboxylic-3,4-anhydride-9,10-imide

e)

CH₃(CH₂)₃CH₂—N $\qquad$ N—CH₂(CH₂)₃CH₃

[Fig. 003]

Glass/ITO/PVA$_{MOWIOL}$/Naphthalene diimide/LiFAl

[Fig. 004]

[Fig. 005]

[Fig. 006]

[Fig. 007]

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 03052841 A1
- US 6387727 B1

### Non-patent literature cited in the description

- **TH. B. SINGH et al.** Applied Physics Letters. *Appl. Phys. Lett.,* 2004, vol. 85, 5409
- Nanoelectronics and Information Technology: Advanced Elecronics Materials and Novel Devices. Nanoelectronics and Information Technology: Advanced Elecronics Materials and Novel Devices. 2003
- **C. D. DIMITRAKOPOULOS ; D. J. MASCARO.** *IBM J. Res. Dev.,* 2001, vol. 45, 11
- **G. HOROWITZ.** *Adv. Funct. Mater.,* 2003, vol. 13, 53
- **V. PODZOROV ; S. E. SYSOEV ; E. LOGINOVA ; V. M. PU-DALOV ; M. E. GERSHENSON.** *Appl. Phys. Lett.,* 2003, vol. 83, 3504
- **J. A. ROGERS ; Z. BAO ; K. BALDWIN ; A. DODABALAPUR ; B. CRONE ; V. R. RAJU ; V. KUCK ; H. KATZ ; K. AMUNDSON ; J. EWING.** *Proc. Natl. Acad. Sci. USA,* 2001, vol. 98, 4835
- Improving organic transistor performance with Schottky contact. **SCHROEDER, R. ; MAJEWSKI, L. A. ; GRELL, M.** Applied Physics Letters. AIP, American Institute of Physics, 09 February 2004, vol. 84, 1004-1006
- General observation of n-type field-effect behaviour in organic semiconductors. **CHUA, L. ; ZAUMSELL, J. ; CHANG, J. ; OU, E. ; HO, P. ; SIRRINGHAUS, H. ; FRIEND, R.** Nature. Nature Publishing Group, 10 March 2005, vol. 434, 194-199
- **H. E. KATZ ; J. JOHNSON ; A. J. LOVINGER ; W. LI.** *J. Am. Chem. Soc,* 2000, vol. 122, 7787
- **LAY-LAY CHUA ; PETER K. H. HO ; HENNING SIRRINGHAUS ; R.H. FRIEND.** *Appl. Phys. Lett.,* 2004, vol. 84, 3400
- **F. DINELLI ; M. MURGIA ; P. LEVY ; M. CAVALLINI ; F. BISCARINI ; D. M. DE LEEUW.** *Phys. Rev. Lett.,* 2004, vol. 92, 116802
- **V. D. MIHAILETCHI ; J. K. J. VAN DUREN ; P. W. M. BLOM ; J. C. HUMMELEN ; R. A. J. JANSSEN ; J. M. KROON ; M. T. RISPENS ; W. J. H. VERHEES ; M. M. WIENK.** *Adv. Func. Mater.,* 2003, vol. 13, 43
- **G. J. MATT ; N. S. SARICIFTCI ; T. FROMHERZ.** *Appl. Phys. Lett.,* 2004, vol. 84, 1570
- **S. M. SZE.** Physics of Semiconductor Devices. Wiley, 1981